# DEMANDE DE BREVET EUROPEEN

(11) **EP 1 878 864 A2**
(43) Date de publication de la demande: **16.01.2008**
(21) Numéro de dépôt: 07112281.6
(22) Date de dépôt: 11.07.2007
(51) Int. Cl.: E06B 3/54

(54) **Panneau feuilleté, procédé de fabrication d'un tel panneau et paroi comprenant un panneau**

(30) Priorité: 12.07.2006 FR 0606352
(71) Demandeur: Moch, Uriel, 34200 Sète (FR)
(72) Inventeur: Moch, Uriel, 34200 Sète (FR)
(74) Mandataire: Zapalowicz, Francis

(57) **Abrégé**

Panneau feuilleté (400), pour paroi (500), comprenant au moins deux plaques rigides (405), en particulier en verre, accolées par l'intermédiaire d'au moins une couche en une matière de collage, et muni, à sa périphérie, d'éléments rigides comprenant une partie intérieure plate s'étendant entre lesdites plaques et noyée au moins en partie dans ladite couche de collage et une partie extérieure et, entre lesdites plaques, d'au moins un organe électrique ; au moins un desdits éléments rigides (501) formant un organe d'accrochage en vue du maintien ou de la fixation dudit panneau par l'intermédiaire de sa partie extérieure, et au moins un autre desdits éléments rigides (401) formant un organe de connexion électrique dont la partie intérieure est reliée électriquement audit organe électrique et dont la partie extérieure (412) est destinée à être accouplée à un élément de connexion électrique extérieure (504), ledit au moins un élément rigide formant organe d'accrochage étant à distance dudit au moins un élément rigide formant organe de connexion électrique.

## Description

La présente invention concerne le domaine des panneaux feuilletés, généralement enverre, couramment utilisés dans le domaine du bâtiment.

On connaît des panneaux feuilletés comprenant deux plaques en verre, accolées par l'intermédiaire d'une couche en une matière de collage, par exemple en butyral de polyvinyle (P.V.B.). Pour fixer ces panneaux de façon à constituer une paroi, par exemple extérieure, il est courant soit de les munir de profilés en U enserrant leurs bords par l'intermédiaire d'un joint élastique et de fixer ces profilés à une structure, soit de les perforer et de les fixer à une structure par des moyens traversant les perforations et permettant les variations de flèches des panneaux vitrés.

La présente invention a notamment pour but de proposer une autre solution applicable en particulier à la fixation de panneaux feuilletés.

La présente invention a notamment pour but de proposer une autre solution applicable en particulier à la fixation de panneaux feuilletés ou en particulier à la connexion électrique de tels panneaux.

La présente invention a tout d'abord pour objet un panneau feuilleté comprenant au moins deux plaques rigides, en particulier en verre, accolées par l'intermédiaire d'au moins une couche en une matière de collage.selon l'invention, ledit panneau est muni, à sa périphérie, d'éléments rigides comprenant une partie intérieure plate s'étendant entre lesdites plaques et noyée au moins en partie dans ladite couche de collage et une partie extérieure et, entre lesdites plaques, d'au moins un organe électrique, au moins un desdits éléments rigides formant un organe d'accrochage en vue du maintien ou de la fixation dudit panneau par l'intermédiaire de sa partie extérieure et au moins un autre desdits éléments rigides formant un organe de connexion électrique dont la partie intérieure est reliée électriquement audit organe électrique et dont la partie extérieure est destinée à être accouplée à un élément de connexion électrique extérieur, ledit au moins un élément rigide formant organe d'accrochage étant à distance dudit au moins un élément rigide formant organe de connexion électrique.

Selon l'invention, au moins l'un desdits éléments rigides formant un organe de connexion électrique est entouré d'une gaine d'isolation électrique dont une partie intérieure s'étend de préférence entre lesdites plaques et est de préférence noyée dans ladite couche de collage et dont une partie extérieure autorise une connexion électrique extérieure étanche sur la partie extérieure de cet élément rigide.

Selon l'invention, la partie extérieure dudit élément rigide formant un organe d'accrochage comprend de préférence une branche terminale d'accrochage qui s'étend parallèlement à une face extérieure d'une plaque et au-dessus et à distance de cette face extérieure et une branche de liaison qui relie sa partie intérieure et cette branche terminale.

Selon l'invention, la partie extérieure dudit élément rigide formant un organe de connexion électrique comprend de préférence une branche terminale de connexion électrique qui s'étend perpendiculairement à ladite face extérieure d'une plaque et une branche de liaison qui relie sa partie intérieure et cette branche terminale de connexion électrique.

Selon l'invention, ladite partie de liaison dudit élément rigide formant un organe de connexion électrique comprend de préférence une branche intermédiaire s'étendant parallèlement à ladite face extérieure d'une plaque et au-dessus de cette dernière.

La présente invention a également pour objet une paroi, qui comprend : une structure ; au moins un panneau comprenant au moins deux plaques rigides, en particulier en verre, accolées par l'intermédiaire d'au moins une couche en une matière de collage, et muni d'éléments rigides présentant une partie intérieure plate s'étendant entre lesdites plaques et noyée dans ladite couche de collage et une partie extérieure ; et des moyens de fixation ou de maintien, déformables élastiquement, coopérant élastiquement d'une part avec ladite structure et d'autre part avec ladite partie extérieure d'au moins un des éléments rigides formant un organe d'accrochag.

Selon l'invention, au moins un élément rigide comprend de préférence un profilé dont une aile intérieure constitue ladite partie intérieure.

Selon l'invention, la partie extérieure dudit profilé comprend une aile extérieure parallèle à une face du panneau et décalée vers l'extérieur par rapport à cette face, ainsi qu'une aile intermédiaire joignant ladite aile intérieure et ladite aile extérieure.

Selon l'invention, la structure comprend de préférence au moins une patte-support sur laquelle une partie inférieure du panneau, exempte d'élément rigide, prend appui, ce panneau étant muni d'éléments rigides formant organes d'accrochage sur ses côtés verticaux et des moyens de fixation ou de maintien coopérant avec ces éléments rigides.

Selon l'invention, lesdits éléments rigides sont de préférence constitués par des profilés qui s'étendent sur approximativement toute la hauteur du panneau.

Selon l'invention, le côté supérieur du panneau peut être avantageusement muni d'au moins un élément rigide constitué par un profilé horizontal qui s'étend sur approximativement toute la longueur du panneau.

Selon l'invention, au moins un panneau peut avantageusement comprendre au moins un organe électrique, en particulier un module photovoltaïque plat, placé entre lesdites plaques et au moins deux éléments rigides isolés électriquement, formant organes de connexion électrique dudit organe électrique.

Selon l'invention, au moins l'un desdits éléments rigides formant organes de connexion électrique est de préférence entouré d'une gaine d'isolation électrique dont une partie intérieure s'étend entre lesdites plaques et noyée dans ladite couche de collage et une partie extérieure autorise une connexion électrique extérieure sur la partie extérieure de cet élément rigide.

Selon l'invention, la paroi peut avantageusement comprendre des boîtiers de connexion électrique aptes à s'accoupler sur des parties terminales de connexion électrique desdits éléments rigides formant organes de connexion électrique.

Selon l'invention, lesdits boîtiers peuvent éventuellement être montés sur la structure par l'intermédiaire de moyens de réglage et/ou de variations de positions relatives.

Selon l'invention, la partie extérieure desdits éléments rigides formant organe de connexion électrique comprennent de préférence des branches terminales de connexion électrique qui s'étend perpendiculairement à une face extérieure des plaques et des branches de liaison qui relient leur parties intérieures et ces branches terminales de connexion électrique, lesdites branches terminales de connexion électrique s'enfichant dans lesdits boîtiers perpendiculairement auxdits panneaux.

Selon l'invention, lesdites parties de liaison desdits éléments rigides formant organes de connexion électrique peuvent avantageusement comprendre des branches intermédiaires s'étendant parallèlement à ladite face extérieure desdites panneaux et au-dessus de cette dernière.

Selon une variante de l'invention, lesdits éléments rigides formant organes d'accrochage et lesdits éléments rigides formant organes de connexion électrique sont de préférence placés sur les côtés verticaux desdits panneaux.

Selon l'invention, lesdites parties extérieures desdits éléments rigides formant organes d'accrochage peuvent avantageusement comprendre des branches terminales d'accrochage qui s'étendent parallèlement à une face extérieure desdits panneaux et au-dessus et à distance de cette face extérieure et des branches de liaison qui relient leurs parties intérieures et ces branches terminales

Selon l'invention, ladite structure comprend de préférence des montants verticaux et des tasseaux fixés sur ces montants et présentant des pattes sur lesquelles prennent appui les côtés inférieurs desdits panneaux.

Selon l'invention, lesdits tasseaux présentent de préférence une section verticale en forme de L et une section horizontale en forme U s'adaptant sur ou dans le profil desdits montants.

Selon l'invention, lesdits moyens de fixation ou de maintien comprennent de préférence respectivement un fil déformable élastiquement, coopérant avec la partie extérieure dudit élément rigide formant organe d'accrochage et avec une aile ou une patte de ladite structure, dans le sens qui les rapproche.

Selon l'invention, lesdits moyens de fixation ou de maintien et lesdits éléments rigides formant organes de connexion électrique comprennent de préférence des parties passant entre les panneaux et la structure.

La présente invention a également pour objet un procédé de fabrication d'un panneau feuilleté comprenant au moins deux plaques, en particulier de verre, accolées par l'intermédiaire d'au moins une couche de collage.

Selon l'invention, ce procédé consiste : à déposer une première couche en une matière de collage sur une face d'une première plaque, à placer sur ladite première couche au moins un ensemble électrique comprenant au moins un organe électrique relié électriquement à au moins un organe de connexion électrique comprenant un élément rigide de connexion électrique entouré par une gaine d'isolation électrique, dans une position telle que l'organe électrique est placé sur ladite première couche et qu'une partie intérieure de l'élément rigide et de la gaine soit placée sur ladite première couche et une partie extérieure de ces derniers s'étende au-delà d'un bord de ladite première plaque ; à déposer une seconde couche en une matière de collage sur ladite première couche, cette seconde couche s'étendant sur ledit organe électrique et sur ladite partie intérieure dudit organe de connexion électrique ; à placer une seconde plaque sur ladite seconde couche de collage ; et à appliquer un traitement de façon que lesdites couches de collage fixent entre elles lesdites plaques en noyant ledit organe électrique et ladite partie intérieure dudit organe de connexion électrique.

La présente invention sera mieux comprise à l'étude de panneaux décrits à titre d'exemples non limitatifs et illustrés par le dessin sur lequel :
- La figure 1 représente une vue partielle en coupe d'un panneau selon l'invention ;
- La figure 2 représente une vue partielle en perspective d'une paroi comprenant des panneaux selon l'invention ;
- La figure 3 représente un détail en perspective de la paroi de la figure 2 ;
- La figure 4 représente une coupe partielle de la paroi de la figure 2 ;
- La figure 5 représente une vue partielle en coupe d'un autre panneau selon l'invention ;
- La figure 6 représente une vue en coupe d'une variante de réalisation d'un panneau selon l'invention ;
- La figure 7 représente une coupe horizontale d'une variante de réalisation d'une paroi mettant en oeuvre le panneau de la figure 6 ;
- La figure 8 représente une vue en perspective de l'arrière de la paroi de la figure 7 ;
- Et la figure 9 représente une vue en perspective de l'avant d'une autre paroi selon l'invention.

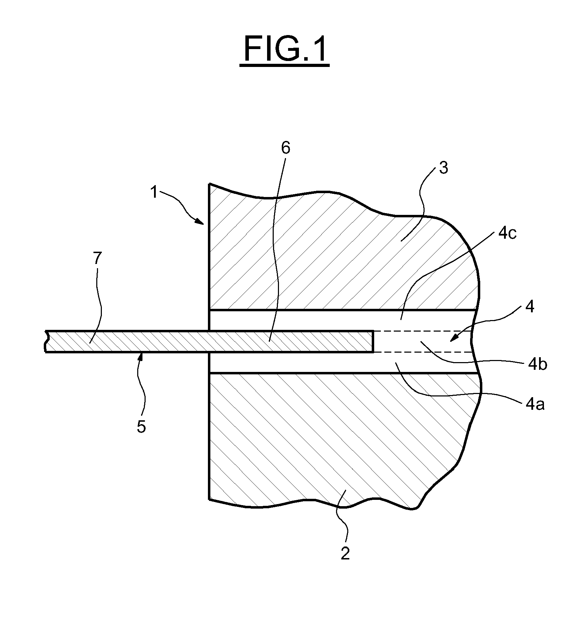

En se reportant à la figure 1, on peut voir qu'on a représenté un panneau feuilleté 1 qui comprend deux plaques rigides parallèles 2 et 3, dans un exemple en verre, accolées par l'intermédiaire d'une couche transparente 4 en une matière de collage, par exemple en butyral de polyvinyle (P.V.B.).

Le panneau feuilleté 1 est muni d'un élément rigide 5 qui présente une partie intérieure plate 6 qui s'étend entre les plaques 2 et 3 et noyée dans la couche de collage 4 et une partie extérieure qui s'étend au-delà de deux bords correspondants des plaques 2 et 3, c'est-à-dire au-delà d'un champ du panneau 1.

Selon un exemple de réalisation, la couche de collage 4 peut être obtenue de la manière suivante.

On dépose sur une face de la plaque 2 une première couche 4a en une matière de collage, on place l'élément rigide 5 à plat sur cette première couche 4a, dans la position précitée, on dépose une couche intermédiaire 4b telle qu'elle ne recouvre pas la partie intérieure 6 de l'élément rigide 5, on dépose une seconde couche 4c sur la couche intermédiaire 4b telle que cette seconde couche 4c recouvre la partie intérieure 6 de l'élément rigide 5, puis on place la plaque 3 sur la seconde couche 4c.

On applique alors les traitements connus pour la fabrication de panneaux feuilletés mettant en oeuvre des couches de matière de collage, notamment à chaud et avec dégazage, de façon que les couches 4a, 4b et 4c s'assemblent entre elles et fixent entre elles les plaques 2 et 3, en noyant la partie intérieure plate 6 de l'élément rigide 5 qui se trouve ainsi solidarisé au panneau 1.

Selon un exemple, la partie intérieure plate 6 de l'élément rigide 5 et les couches 4a, 4b et 4c peuvent présenter des épaisseurs comprises entre 0,6 mm et 1,2 mm, les plaques pouvant présenter des épaisseurs comprises entre 5 et 15 mm.

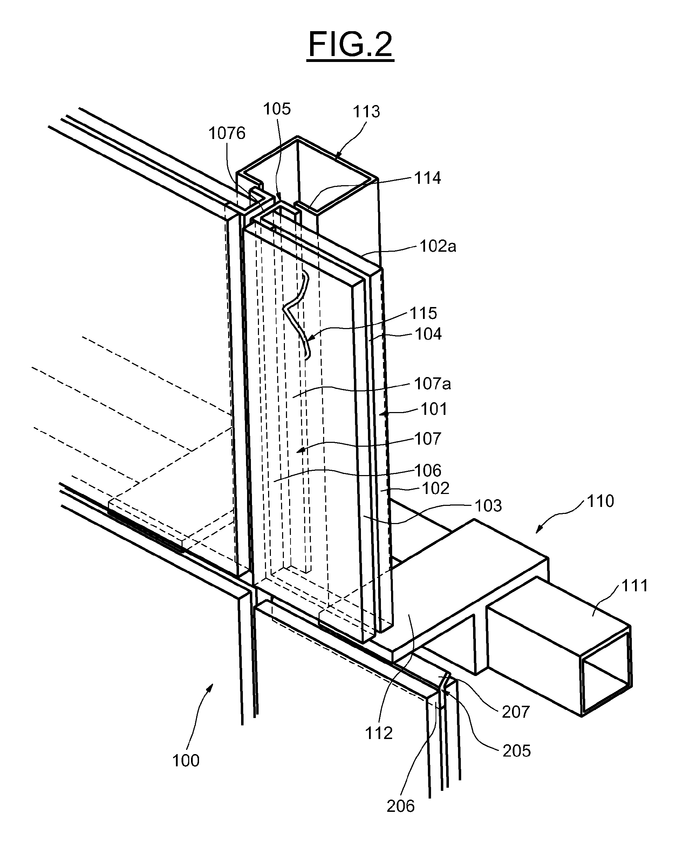

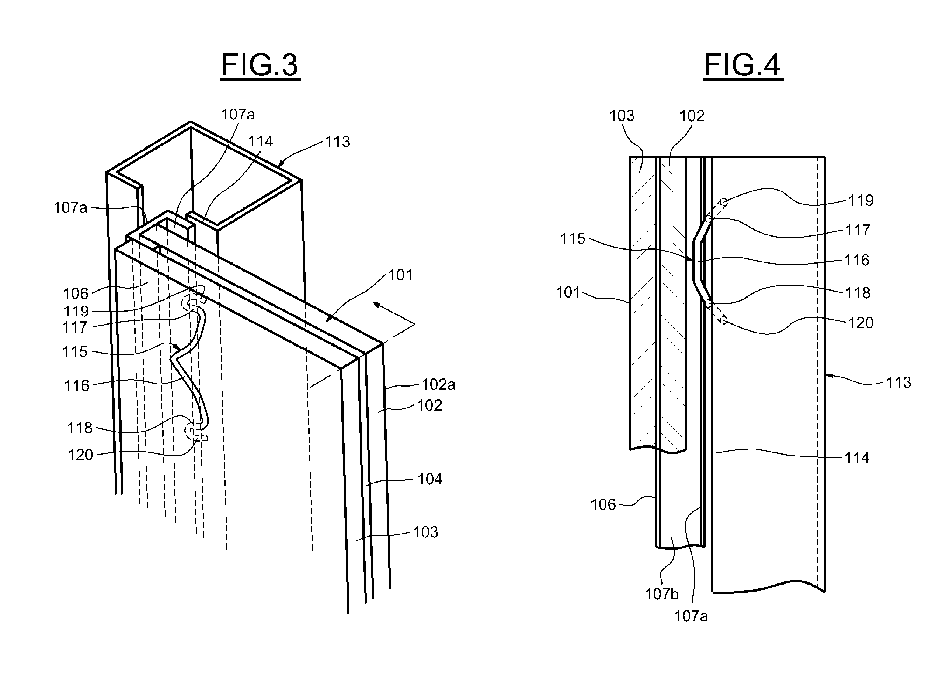

En se reportant aux figures 2 à 4, on peut voir qu'on a représenté une paroi verticale 100 constituée par plusieurs panneaux feuilletés 101 rectangulaires, en verre, placés les uns à côté et au-dessus des autres et à distance les uns des autres et par une structure-support 110 placée en arrière des panneaux 101.

Chaque panneau feuilleté 101 est muni, sur ses deux côtés verticaux opposés, de profilés rigides 105 correspondant à l'élément rigide 5 du panneau 1, ces profilés 105 étant de section en forme de U et formant des organes d'accrochage.

Ces profilés 105 s'étendent sur toute la hauteur du panneau 101 et comprennent une aile intérieure plate 106 noyée dans la matière de collage 104 interposée entre deux plaques en verre 102 et 103 et une partie extérieure 107.

Dans cet exemple, la partie extérieure 107 comprend une aile extérieure 107a qui s'étend parallèlement et qui forme une partie terminale d'accrochage, en vis-à-vis et à distance d'une face arrière 102a du panneau 101 et une aile intermédiaire 107b qui relie, perpendiculairement, l'aile intérieure 106 et l'aile extérieure 107a.

Chaque panneau feuilleté 101 est en outre muni, sur son côté supérieur, d'un profilé rigide 205 correspondant à l'élément rigide 5 du panneau 1, ce profilé 205 étant de section en forme de V très ouvert.

Ce profilé 205 s'étend sur toute la longueur du panneau 101 et comprend une aile intérieure plate 206 noyée dans la matière de collage 104 et une aile extérieure 207 inclinée vers l'arrière et constituant des renvois d'eau vers l'avant.

La structure 110 comprend des longerons horizontaux 111 parallèles aux panneaux 101, qui portent des paires de pattes horizontales 112 espacées, s'étendant vers l'avant et sur lesquelles les champs ou bords inférieurs des panneaux 101 sont respectivement en appui.

La structure 110 comprend en outre des montants 113 passant devant les longerons 111. Les montants 113 sont de section en forme de C, les espaces verticaux séparant leurs ailes opposées 114 étant situés en face des espaces verticaux séparant les rangées verticales de panneaux 101.

Les panneaux 101 sont fixés sur les montants 113 par l'intermédiaire de plusieurs moyens espacés de fixation ou de maintien 115 déformables élastiquement, qui coopèrent, élastiquement, respectivement d'une part avec les ailes 114 des montants 113 et d'autre part avec les ailes extérieures 107a des profilés verticaux 105 des panneaux 101.

Ainsi, de tels moyens de fixation ou de maintien 115 déformables élastiquement, éventuellement en combinaison avec des profilés 105 déformables élastiquement, sont aptes à permettre des variations de positions relatives des différents panneaux 101 par rapport à la structure 110, dues par exemple aux variations de températures et aux flexions dues par exemple aux effets du vent.

Avantageusement, les moyens de fixation ou de maintien 115 sont constitués par des fils élastiques pliés présentant une portion centrale 116, des portions intermédiaires 117 et 118 passant entre les ailes 107a et 114 et des portions d'extrémités 119 et 120. De tels moyens de fixation ou de maintien 115 sont en particulier décrits dans le brevet EP-A-325 642.

Ces moyens 115 sont installés de telle sorte que les ailes extérieures 107a des profilés verticaux 105 des panneaux 101 sont pincées entre la portion centrale 116 et les portions intermédiaires 117 et 118 et que les ailes 114 des montants 113 sont pincées entre les portions intermédiaires 117 et 118 et les portions d'extrémités 119 et 120, les ailes 107a et les ailes 114 adjacentes s'étendant à l'opposé les unes de autres et les portions intermédiaires passant entre les ailes 107a et les ailes 114 adjacentes.

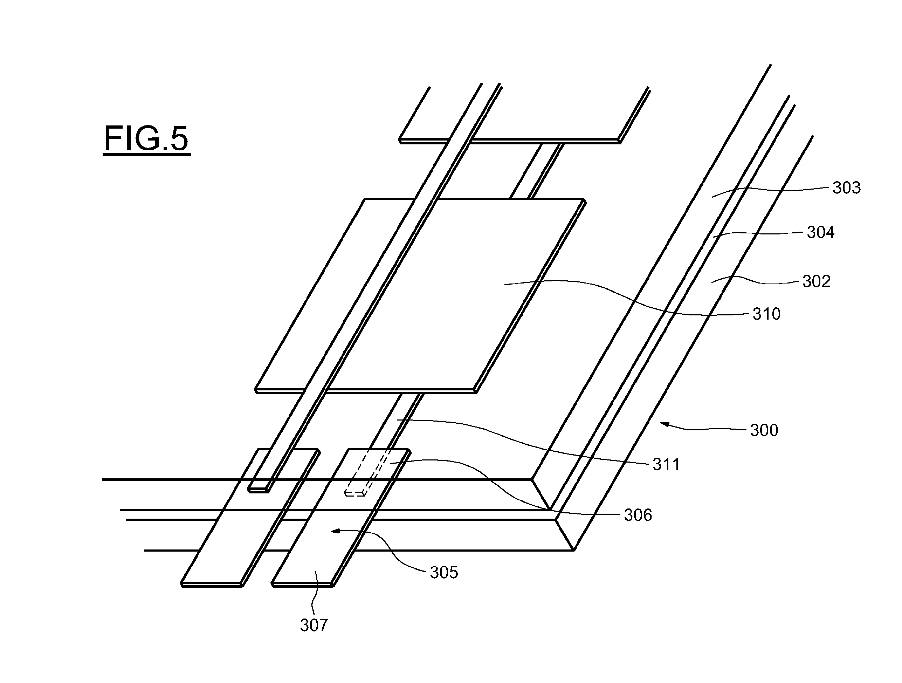

En se reportant maintenant à la figure 5, on peut voir qu'on a représenté un panneau feuilleté 301 comprenant deux plaques en verre 302 et 303 accolées par l'intermédiaire d'une couche de collage 304.

Ce panneau 301 est muni de deux pattes rigides de connexion électrique 305, isolées électriquement, correspondant à l'élément rigide 5 du panneau 1 et comprenant des parties intérieures 306 noyées dans la couche transparente de collage 304 et des parties extérieures 307 en vue de former des organes de connexion électrique extérieure.

Ce panneau 301 est en outre muni, entre ses panneaux 302 et 303, d'au moins un organe électrique, comprenant par exemple des modules photovoltaïques plats et fins 310, noyés dans la couche transparente de collage 304, par exemple montés électriquement en série, dont les pôles électriques d'un dernier module sont reliés électriquement aux parties intérieures 306 des pattes 305 par l'intermédiaire de fils électrique plats et fins 311 de connexion.

Avantageusement, en référence à la description de la figure 1, les modules photovoltaïques 310 et leurs moyens de connexion sont placés entre la première couche 4a et la seconde couche 4c, la couche intermédiaire 4b présentant par exemple des ouvertures correspondant aux modules 310.

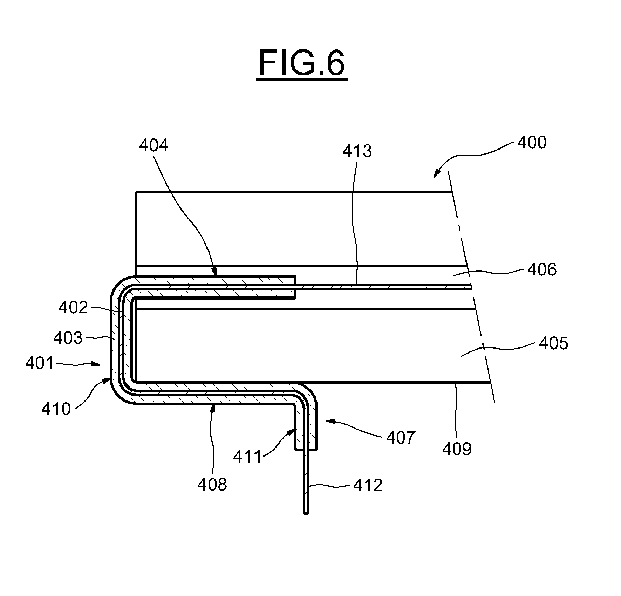

En se reportant à la figure 6, on peut voir qu'on a représenté un panneau 400 constituant une variante de réalisation du panneau 300 de la figure 5.

Ce panneau 400 comprend deux organes de connexion électrique 401 qui comprennent respectivement une patte de connexion électrique 402 entourée par une gaine d'isolation électrique 403.

Ces organes de connexion électrique 401 présentent une partie intérieure 404 placée entre ses plaques 405 et noyée de façon étanche dans une couche de collage 406 séparant ces plaques et une partie extérieure 407. Cette partie extérieure 407 présente une branche intermédiaire 408 qui s'étend sur une face extérieure 409 du panneau 400, une branche de liaison 410 qui relie sa partie intérieure 404 et la branche intermédiaire 408 et une partie terminale 411 qui s'étend perpendiculairement à la face 409 du panneau 400. La partie terminale 411 est exempte de gaine 403 sur au moins sa partie d'extrémité de telle sorte que la patte 402 présente une partie d'extrémité dénudée 412 en vue d'une connexion électrique extérieure. L'extrémité intérieure 413 de la patte 402 est reliée, comme précédemment, à des connexions de cellules photovoltaïque.

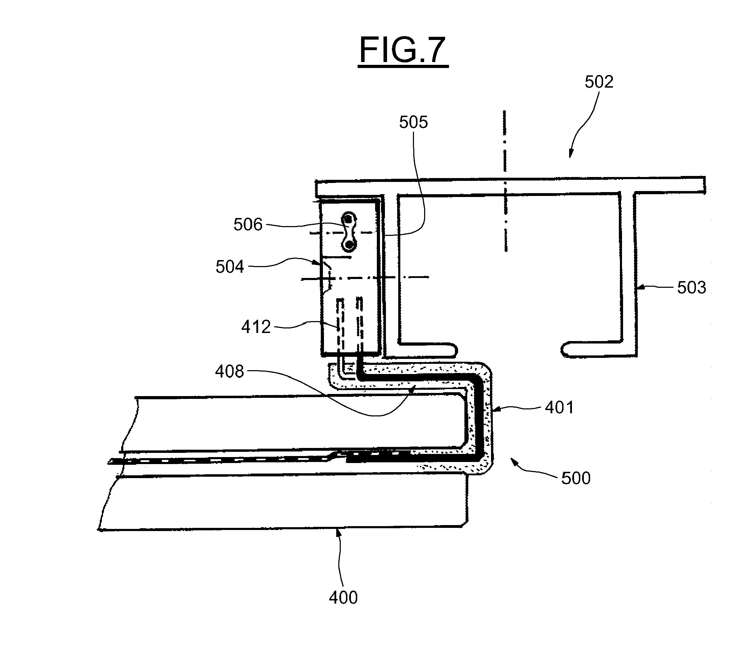

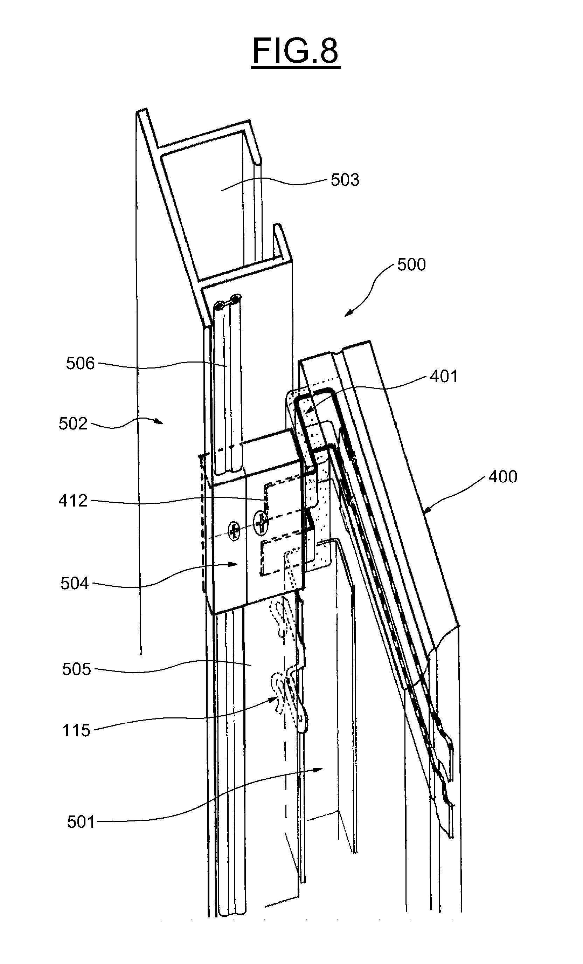

En se reportant aux figures 7 et 8, on va maintenant décrire une paroi verticale 500 qui comprend des panneaux 400 et qui généralement construite comme la paroi 100.

Les panneaux 400 sont munis, sur la partie supérieure d'au moins l'un de leur côtés verticaux, de deux organes de connexion 401 proches l'un de l'autre et d'organes d'accrochage formés par des profilés 501, équivalent aux profilés 105, sur le reste de ce côté, les organes de connexion 401 étant distants mais proches des extrémités correspondantes des organes d'accrochage 501.

La structure 502 de cette paroi comprend des montants 503, équivalents aux montants 113.

La paroi 500 comprend en outre des boîtiers de connexion électrique 504 qui sont, selon une variante de réalisation, fixés contre les faces latérales 505 des montants 503, par exemple par des vis, et qui sont disposés et adaptés pour recevoir par enfichage les parties d'extrémité dénudée 412 des organes de connexion électrique 401, par un engagement perpendiculaire à la paroi 500, ou aux panneaux 400, et par déplacement de ces panneaux selon cette direction.

Avantageusement, les boîtiers 504 et les parties d'extrémité 411 des organes de connexion électrique sont adaptées, par des moyens connus, par exemple par conjugaison de formes, pour s'accoupler de manière étanche.

Les différents boîtiers 504 montés sur un même montant 503 et connectés à différents panneaux 400 placés les uns au-dessus des autres sont avantageusement reliés par des fils de connexion électrique 506 qui s'étendent le long de ce montant.

Les différents fils de connexion électrique 506 montés sur différents montants 503 peuvent avantageusement être reliés pour réaliser une connexion centralisée des différents panneaux formant au moins partiellement la paroi 500.

Pour réaliser la paroi 500, on monte la structure 502, on fixe aux bons endroits les boîtiers de connexion électrique et les fils de connexion électrique 506, on installe les panneaux en enfichant les organes de connexion électrique 401 et on installe les organes de fixation ou de maintien 115 comme décrit précédemment.

Avantageusement, les boîtiers 504 peuvent être montés sur la structure 502 par l'intermédiaire de moyens de réglage et/ou de variations de positions relatives, comprenant par exemple des vis pouvant être réglées le long de passages oblongs, des cales, des ressorts de compensation de variations de positions relatives.

Selon une autre variante de réalisation, les boîtiers 504 peuvent être accouplés de façon étanche aux panneaux 400, avant ou après le montage de ces panneaux sur la structure 502, sans être fixés à cette structure.

Selon une variante d'exécution, les profilés 501 des panneaux 400 pourraient s'étendre sur toute leur hauteur. Dans ce cas, comme les portions intermédiaires 117 et 118 des moyens de fixation ou de maintien 115 passent entre les ailes 107a des profilés 501 des panneaux 400 et les ailes 114 des montants 503, correspondant aux précédentes, les branches intermédiaires 408 des organes de connexion électrique 401 peuvent présenter une épaisseur telle que ces branches 408 peuvent passer au travers de l'espace séparant ces ailes des panneaux 400 et des montants 503, soit librement soit sans constituer une surépaisseur.

Selon une autre variante, les profilés 501 pourraient présenter des échancrures pour laisser passer les parties 408 des organes de connexion électrique.

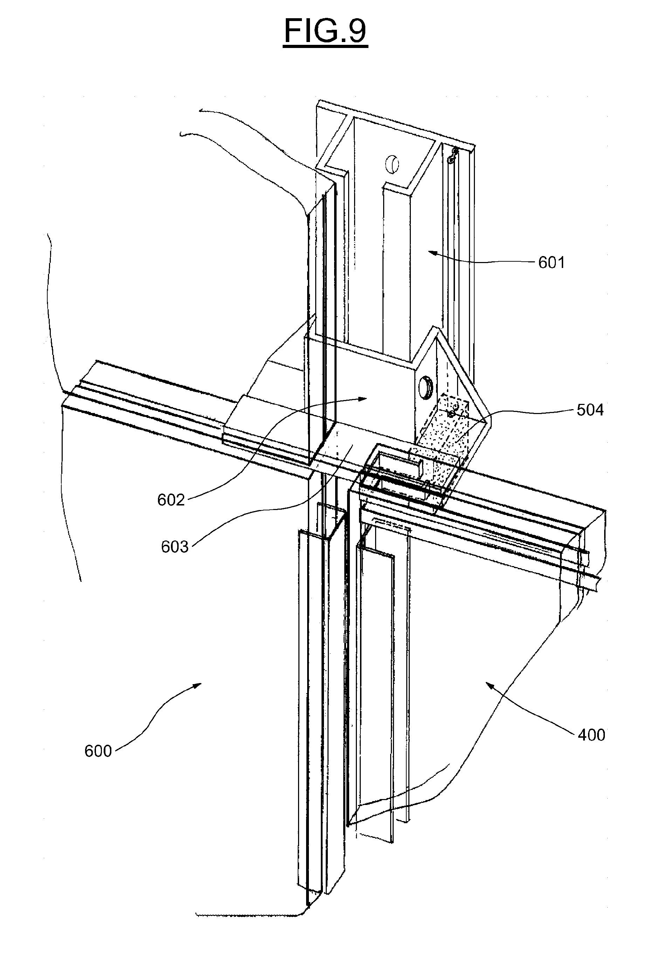

En se reportant à la figure 9, on peut voir qu'on a représenté une paroi 600 qui se différencie des parois 100 et 500 décrite précédemment par le fait que ses montants 601 portent des tasseaux 602 en différents endroits de sa hauteur en vue de porter différents panneaux 400 par leurs coins horizontaux inférieurs.

Ce tasseau 602 présente une section horizontale en forme de U emboîtée sur le montant 601 et une section verticale en forme de L de manière à présenter une plateforme 603 d'appui de deux panneaux 400 adjacents horizontalement, cette plateforme 603 s'étendant en avant du montant 601 et sur ses côtés latéraux opposés. La structure de cette paroi 600 peut alors être démunie de traverse pour porter les panneaux qui la composent.

Selon une autre variante de réalisation, les boîtiers 504 peuvent être fixés contre les montants 601 ou au-dessous ou au-dessus de la plateforme 603.

Bien entendu, les panneaux pourraient être munis de plusieurs organes de connexion électriques ; les panneaux pourraient être munis d'organes d'accrochage présentant toute formes adaptées aux moyens de fixation et à la structure choisie ; la périphérie des panneaux précités n'est pas limitée à une forme carrée ou rectangulaire ; les parois précités pourraient être inclinées, présenter des parties formant des angles entre elles, et présenter en fait toutes formes et tous pourtours.

Toutes combinaisons, totales ou partielles, de ce qui vient d'être décrit en référence aux différentes figures sont naturellement possibles.

## Revendications

1. Panneau feuilleté comprenant au moins deux plaques rigides, en particulier en verre, accolées par l'intermédiaire d'au moins une couche en une matière de collage, **caractérisé par le fait qu'**il est muni, à sa périphérie, d'éléments rigides comprenant une partie intérieure plate (6) s'étendant entre lesdites plaques et noyée au moins en partie dans ladite couche de collage (4) et une partie extérieure (7) et, entre lesdites plaques, d'au moins un organe électrique (310) ;
au moins un desdits éléments rigides (105) formant un organe d'accrochage en vue du maintien ou de la fixation dudit panneau par l'intermédiaire de sa partie extérieure ;
au moins un autre desdits éléments rigides (401) formant un organe de connexion électrique dont la partie intérieure (404) est reliée électriquement audit organe électrique et dont la partie extérieure (407) est destinée à être accouplée à un élément de connexion électrique extérieure (504) ;
et ledit au moins un élément rigide (105) formant organe d'accrochage étant à distance dudit au moins un élément rigide (401) formant organe de connexion électrique.

2. Panneau selon la revendication 1, **caractérisé par le fait qu'**au moins l'un desdits éléments rigides formant un organe de connexion électrique est entouré d'une gaine d'isolation électrique dont une partie intérieure (404) s'étend entre lesdites plaques et est noyée dans ladite couche de collage (4) et dont une partie extérieure (407) autorise une connexion électrique extérieure étanche sur la partie extérieure de cet élément rigide.

3. Panneau selon l'une des revendications 1 et 2, **caractérisé par le fait que** la partie extérieure dudit élément rigide formant un organe d'accrochage comprend une branche terminale d'accrochage qui s'étend parallèlement à une face extérieure d'une plaque et au-dessus et à distance de cette face extérieure et une branche de liaison qui relie sa partie intérieure et cette branche terminale et que la partie extérieure dudit élément rigide formant un organe de connexion électrique comprend une branche terminale de connexion électrique qui s'étend perpendiculairement à ladite face extérieure d'une plaque et une branche de liaison qui relie sa partie intérieure et cette branche terminale de connexion électrique.

4. Panneau selon la revendication 3, **caractérisé par le fait que** ladite partie de liaison dudit élément rigide formant un organe de connexion électrique comprend une branche intermédiaire s'étendant parallèlement à ladite face extérieure d'une plaque et au-dessus de cette dernière.

5. Paroi, **caractérisée par le fait qu'**elle comprend :
une structure (113) ;
au moins un panneau (101) comprenant au moins deux plaques rigides, en particulier en verre, accolées par l'intermédiaire d'au moins une couche en une matière de collage, et muni d'éléments rigides (5, 105, 207, 307) présentant une partie intérieure plate (6) s'étendant entre lesdites plaques et noyée dans ladite couche de collage (4) et une partie extérieure (7) ;
et des moyens de fixation ou de maintien (115), déformables élastiquement, coopérant élastiquement d'une part avec ladite structure et d'autre part avec ladite partie extérieure (107) d'au moins un des éléments rigides formant un organe d'accrochage (105).

6. Paroi selon la revendication 5, **caractérisée par le fait qu'**au moins un élément rigide comprend un profilé (105) dont une aile intérieure (106) constitue ladite partie intérieure.

7. Paroi selon l'une des revendications 5 et 6, **caractérisée par le fait que** la partie extérieure (107) dudit profilé comprend une aile extérieure (107a) parallèle à une face du panneau et décalée vers l'extérieur par rapport à cette face, ainsi qu'une aile intermédiaire (107b) joignant ladite aile intérieure et ladite aile extérieure.

8. Paroi selon l'une quelconque des revendications 5 à 7, **caractérisée par le fait que** la structure comprend au moins une patte-support sur laquelle une partie inférieure du panneau, exempte d'élément rigide, prend appui, ce panneau étant muni d'éléments rigides (105) formant organes d'accrochage sur ses côtés verticaux et des moyens de fixation ou de maintien (115) coopérant avec ces éléments rigides (105).

9. Paroi selon l'une quelconque des revendications 5 à 8, **caractérisée par le fait que** lesdits éléments rigides sont constitués par des profilés qui s'étendent sur approximativement toute la hauteur du panneau.

10. Paroi selon l'une quelconque des revendications 5 à 9, **caractérisée par le fait que** le côté supérieur du panneau est munis d'au moins un élément rigide constitué par un profilé horizontal qui s'étend sur approximativement toute la longueur du panneau.

11. Paroi selon l'une quelconque des revendications 5 à 10, **caractérisée par le fait qu'**au moins un panneau comprend au moins un organe électrique, en particulier un module photovoltaïque plat (310), placé entre lesdites plaques et au moins deux éléments rigides (305) isolés électriquement, formant organes de connexion électrique dudit organe électrique.

12. Paroi selon la revendication 11, **caractérisée par le fait qu'**au moins l'un desdits éléments rigides formant organes de connexion électrique est entouré d'une gaine d'isolation électrique dont une partie intérieure s'étend entre lesdites plaques et noyée dans ladite couche de collage (4) et une partie extérieure (7) autorise une connexion électrique extérieure sur la partie extérieure de cet élément rigide.

13. Paroi selon l'une des revendications 11 et 12, **caractérisée par le fait qu'**elle comprend des boîtiers de connexion électrique aptes à s'accoupler sur des parties terminales de connexion électrique desdits éléments rigides formant organes de connexion électrique.

14. Paroi selon la revendication 13, **caractérisée par le fait que** les boîtiers sont montés sur la structure par l'intermédiaire de moyens de réglage et/ou de variations de positions relatives.

15. Paroi selon l'une quelconque des revendications 11 à 14, **caractérisée par le fait que** la partie extérieure desdits éléments rigides formant organe de connexion électrique comprennent des branches terminales de connexion électrique qui s'étend perpendiculairement à une face extérieure des plaques et des branches de liaison qui relient leur parties intérieures et ces branches terminales de connexion électrique, lesdites branches terminales de connexion électrique s'enfichant dans lesdits boîtiers perpendiculairement auxdits panneaux.

16. Paroi selon l'une quelconque des revendications 11 à 15, **caractérisée par le fait que** lesdites parties de liaison desdits éléments rigides formant organes de connexion électrique comprennent des branches intermédiaires s'étendant parallèlement à ladite face extérieure desdites panneaux et au-dessus de cette dernière.

17. Paroi selon l'une quelconque des revendications 11 à 16, **caractérisée par le fait que** lesdits éléments rigides formant organes d'accrochage et lesdits éléments rigides formant organes de connexion électrique sont placés sur les côtés verticaux desdits panneaux.

18. Paroi selon l'une quelconque des revendications 5 à 17, **caractérisée par le fait que** lesdites parties extérieures desdits éléments rigides formant organes d'accrochage comprennent des branches terminales d'accrochage qui s'étendent parallèlement à une face extérieure desdits panneaux et au-dessus et à distance de cette face extérieure et des branches de liaison qui relient leurs parties intérieures et ces branches terminales

19. Paroi selon l'une quelconque des revendications 5 à 18, **caractérisée par le fait que** ladite structure comprend des montants verticaux et des tasseaux fixés sur ces montants et présentant des pattes sur lesquelles prennent appui les côtés inférieurs desdits panneaux.

20. Paroi selon la revendication 19, **caractérisée par le fait que** lesdits tasseaux présentent une section verticale en forme de L et une section horizontale en forme U s'adaptant sur ou dans le profil desdits montants.

21. Paroi selon l'une quelconque des revendications 5 à 20, **caractérisée par le fait que** lesdits moyens de fixation ou de maintien comprennent respectivement un fil déformable élastiquement, coopérant avec la partie extérieure dudit élément rigide formant organe d'accrochage et avec une aile ou une patte de ladite structure, dans le sens qui les rapproche.

22. Paroi selon l'une quelconque des revendications 11 à 21, **caractérisée par le fait que** lesdits moyens de fixation ou de maintien (115) et lesdits éléments rigides (305) formant organes de connexion électrique comprennent des parties (118, 119 - 408) passant entre les panneaux et la structure.

23. Procédé de fabrication d'un panneau feuilleté comprenant au moins deux plaques, en particulier de verre, accolées par l'intermédiaire d'au moins une couche de collage, **caractérisé par le fait qu'**il consiste :
à déposer une première couche (4a) en une matière de collage sur une face d'une première plaque (2),
à placer sur ladite première couche au moins un ensemble électrique comprenant au moins un organe électrique (310) relié électriquement à au moins un organe de connexion électrique (401) comprenant un élément rigide de connexion électrique (402) entouré par une gaine d'isolation électrique (403), dans une position telle que l'organe électrique est placé sur ladite première couche et qu'une partie intérieure (404) de l'élément rigide et de la gaine soit placée sur ladite première couche et une partie extérieure (407) de ces derniers s'étende au-delà d'un bord de ladite première plaque,
à déposer une seconde couche (4b) en une matière de collage sur ladite première couche, cette seconde couche s'étendant sur ledit organe électrique et sur ladite partie intérieure dudit organe de connexion électrique,
à placer une seconde plaque (3) sur ladite seconde couche de collage,
et à appliquer un traitement de façon que lesdites couches de collage fixent entre elles lesdites plaques en noyant ledit organe électrique et ladite partie intérieure dudit organe de connexion électrique.
